# EUROPÄISCHE PATENTSCHRIFT

(11) **EP 4 429 114 B1**
(45) Veröffentlichungstag und Bekanntmachung des Hinweises auf die Patenterteilung: **30.09.2026**
(21) Anmeldenummer: 23160507.2
(22) Anmeldetag: 07.03.2023
(51) Int. Cl.: H03K 17/96, H02G 3/14

(54) **ELEKTRONISCHES ELEKTROINSTALLATIONSGERÄT FÜR DIE GEBÄUDEINSTALLATION**
ELECTRONIC ELECTRICAL INSTALLATION DEVICE FOR BUILDING INSTALLATION
APPAREIL ÉLECTRONIQUE D'INSTALLATION POUR L'INSTALLATION DE BÂTIMENTS

(43) Veröffentlichungstag der Anmeldung: 11.09.2024
(73) Patentinhaber: GIRA Giersiepen GmbH & Co. KG, 42477 Radevormwald (DE)
(72) Erfinder: SEIFERT, Roland, 59071 Hamm (DE); LOHMANN, Achim, 58579 Schalksmühle (DE)
(74) Vertreter: Dr. Solf & Zapf Patent- und Rechtsanwalts PartG mbB

(56) Entgegenhaltungen:
- DE-U1- 202005 018 658
- KR-B1- 101 255 829
- US-A1- 2016 124 567
- US-B2- 11 424 743

## Beschreibung

Die vorliegende Erfindung betrifft ein elektronisches Elektroinstallationsgerät, insbesondere für die Gebäudeinstallationstechnik, umfassend einen Gerätesockel, in dem eine elektrische Auswerteschaltung angeordnet ist, und einen auf der Oberseite des Gerätesockels angeordneten Bedienaufsatz.

Derartige Elektroinstallationsgeräte, wie zum Beispiel elektronische Schalter, werden üblicherweise für die Unterputzinstallation verwendet, wobei der Gerätesockel sich innerhalb einer Wand befindet. Der bekannte Bedienaufsatz besteht insbesondere aus einem Träger, auf dem eine Leiterplatte mit elektronischen Bauteilen befestigt ist. Zudem ist auf dieser eine kapazitive Sensorfläche, die als sogenannter Touch-Sensor dient, angeordnet. Diese Anordnung wird üblicherweise dann zu einem geschlossenen Bauteil verarbeitet. Dieses Bauteil muss mittels mechanischer Verbindungselemente und über elektrische Kontakte mit dem Sockelteil verbunden werden. Aufgrund dieses Aufbaus des Bauteils ergibt sich eine relativ hohe Bauweise des Elektroinstallationsgerätes und ein hoher Herstellungsaufwand.

Die US 2016/124567 A1 offenbart ein elektronisches Elektroinstallationsgerät, umfassend einen Gerätesockel, in dem eine elektrische Auswerteschaltung angeordnet ist, und einen auf dessen Oberseite angeordneten Bedienaufsatz. Der Bedienaufsatz ist mehrteilig ausgebildet und weist eine Abdeckplatte auf, welche eine kapazitive Sensorfläche überdeckt. Ein Rahmen des Bedienaufsatzes nimmt die Abdeckplatte und die kapazitive Sensorfläche auf. Über hervorstehende Arme des Rahmens ist der Rahmen mit dem Gerätesockel unter Ausbildung einer Steckverbindung mechanisch verbindbar. Beabstandet zu den Armen weist der Rahmen Durchgangsöffnungen auf, in welchen metallische Pins mit jeweils einer Feder vorgespannt angeordnet sind. Über die metallischen Pins ist die elektrische Verbindung zwischen der kapazitiven Sensorfläche und der elektrischen Auswerteschaltung realisiert.

Die US 11,424,743 B2 offenbart ein elektronisches Kontrollelement für Sicherheitsfunktionen in einem Fahrzeug mit zwei kapazitiven Sensoren, welche mit einer Auswerteplatine elektrisch verbunden sind. Die kapazitiven Sensoren sind jeweils mit mäandernden elektrischen Leiterbahnen ausgebildet. Die beiden kapazitiven Sensoren weisen einen Abstand zueinander auf.

Die KR 10-1255829 B1 offenbart ein elektronisches Elektroinstallationsgerät mit einem Gerätesockel und einem mehrteiligen Bedienaufsatz. Der Bedienaufsatz weist u.a. ein Trägerbauteil, eine mittels einer Platine ausgebildete elektrische Auswerteschaltung und eine Abdeckplatte auf. Ein kapazitiver Sensor ist einteilig mit dem Trägerbauteil des Bedienaufsatzes ausgebildet. Der kapazitive Sensor könnte auch einteilig mit der Abdeckplatte des Bedienaufsatzes ausgebildet sein. Die Abdeckplatte ist mit dem Gerätesockel verschraubt.

Der vorliegenden Erfindung liegt die Aufgabe zugrunde, den Herstellungs- und Montageaufwand zu reduzieren und gleichzeitig die Montagehöhe des Bauteils zu verringern.

Erfindungsgemäß wird dies durch die Merkmale des Anspruchs 1 erreicht. Erfindungsgemäß wird ein Bedienaufsatz geschaffen, in dem die kapazitive Sensorfläche und die elektrischen Leiterbahnen integriert sind und zudem die mechanischen Verbindungsmittel zwischen dem Bedienaufsatz und dem Gerätesockel und die elektrischen Kontakte mit dem Bedienaufsatz einteilig verbunden sind. Hierdurch ergibt sich ein kompakter, vorteilhafterweise einteiliger Aufbau des Bedienaufsatzes. Hierbei ist es von Vorteil, wenn der kapazitive Sensor als Folie aufgeklebt oder in dem Bedienaufsatz in der Wandung des Formteils miteingegossen bzw. umspritzt ist. Vorteilhafterweise sind die elektrischen Leiterbahnen ebenfalls miteingegossen, so dass diese ein integrierter Bestandteil des Bedienaufsatzes sind, der insbesondere als Kunststoffspritzgussteil, insbesondere als Mehrkomponenten-Spritzgussteil, hergestellt ist. Gemäß einer weiteren Ausführung ist die kapazitive Sensorfläche vorteilhaft als eine auf Kunststoff gedruckte elektrisch leitfähige Sensorfläche ausgebildet.

Erfindungsgemäß ist es vorteilhaft, wenn die elektrische bzw. elektronische Auswerteschaltung im Gerätesockel angeordnet ist. Vorzugsweise können jedoch auch Bauteile der Auswerteschaltung im Bedienaufsatz mitintegriert sein.

Weiterhin ist es von Vorteil, wenn die gesamte Oberfläche des Bedienaufsatzes mit der kapazitiven Sensorfläche bedeckt ist. Insbesondere ist die kapazitive Sensorfläche in zwei zueinander symmetrische, gleich große, voneinander getrennte kapazitive Sensorteilflächen aufgeteilt. Vorteilhafterweise besitzt der Bedienaufsatz eine rechteckige, insbesondere quadratische, oder runde Form. Hierbei kann insbesondere die Trennlinie zwischen den beiden voneinander getrennten Sensorteilflächen mit der Mittelachse des Bedienaufsatzes zusammenfallen oder senkrecht zur Mittelachse verlaufen.

Bei einer Anordnung der Sensorteilflächen parallel zur Mittelachse, d. h. in vertikaler Richtung, ist es möglich, zwischen einer Bedienung links von der Mittelachse und rechts von der Mittelachse zu unterscheiden. Bei einer Anordnung der Sensorteilflächen in horizontaler Richtung, d. h. senkrecht zur Mittelachse des Bedienaufsatzes, kann zwischen einer Bedienung von oberhalb der Trennlinie und unterhalb der Trennlinie unterschieden werden. Der Bedienaufsatz kann insbesondere durch eine Verdrehung um 90° von dem vertikalen Verlauf der Sensorteilflächen in den horizontalen Verlauf und umgekehrt überführt werden. Wenn erfindungsgemäß zwei kapazitive Sensorteilflächen ausgebildet sind, werden vorteilhafterweise drei Leiterbahnen vorgesehen, und zwar eine Leiterbahn zur Verbindung mit einer für beide Teilflächen gemeinsamen Masse und jeweils eine spannungsführende Leiterbahn für jede Sensorteilfläche. Erfindungsgemäß ist es weiterhin von Vorteil, wenn die Steckverbindungsvorrichtung elektrische Kontaktflächen aufweist, von denen jeweils eine mit einer der Leiterbahnen verbunden ist. Hierbei ist es von Vorteil, wenn diese elektrischen Kontaktflächen jeweils um 90° zueinander verdreht beziehungsweise versetzt angeordnet sind. Im Gerätesockel sind zweckmäßigerweise vier elektrische Gegenkontaktflächen ausgebildet, von denen jeweils eine im montierten Zustand des Bedienfortsatzes mit einer der Kontaktflächen des Bedienaufsatzes in Kontakt steht. Hierdurch ist auch bei einer Verdrehung des Bedienaufsatzes um 90° eine Kontaktierung mit dem Sockelteil gewährleistet. Erfindungsgemäß ist es von Vorteil, wenn die Steckverbindungsvorrichtung aus vier jeweils um 90° zueinander versetzten Steckfortsätzen gebildet ist, die zueinander gleich beabstandet sind und zur Mittelachse des Bedienaufsatzes denselben Abstand besitzen. Der Gerätesockel weist hierbei jeweils vier um 90° zueinander versetzte und zur Mittelachse des Gerätesockels gleich beabstandete Einstecköffnungen auf, wobei diese Einstecköffnungen der Form der Steckfortsätze angepasst sind und elektrische Gegenkontaktflächen aufweisen. Die Mittelachse des Bedienaufsatzes fällt vorteilhafterweise mit der Mittelachse des Gerätesockels zusammen.

Weiterhin ist es erfindungsgemäß vorteilhaft, wenn an einem der Steckfortsätze ein nasenartiger Vorsprung angeformt ist sowie im Sockelteil in zwei um 90° zueinander versetzten Einstecköffnungen des Gerätesockels jeweils eine dem nasenartigen Vorsprung angepasste Aufnahmeöffnung ausgebildet ist. Hierdurch ist es möglich, dass der Bedienaufsatz sowohl für einen einkanaligen Gerätesockel verwendet werden kann, d. h. einen Gerätesockel, dessen Auswerteschaltung nur einen Verbraucher ansteuert, als auch für einen zweikanaligen Gerätesockel, mit dem zwei unterschiedliche Verbraucher angesteuert werden, denn der Gerätesockel ist durch die jeweilige Position der nasenartigen Fortsätze des Steckfortsatzes in der Lage, durch die gewählte Position die damit gewählte Funktion programmtechnisch über seine Gegenkontaktflächen zu erkennen und so seine Funktion voreinzustellen. Vorteilhafte Ausführungsformen der Erfindung sind in den Unteransprüchen enthalten.

Anhand des in den beiliegenden Zeichnungen dargestellten Ausführungsbeispiels wird die Erfindung näher erläutert. Es zeigen:
- Fig. 1: eine Aufsicht auf einen erfindungsgemäßen Bedienaufsatz in vertikaler Position seiner zwei kapazitiven Sensorteilflächen,
- Fig. 2: eine Aufsicht auf einen erfindungsgemäßen Bedienaufsatz mit horizontaler Position seiner zwei kapazitiven Sensorteilflächen,

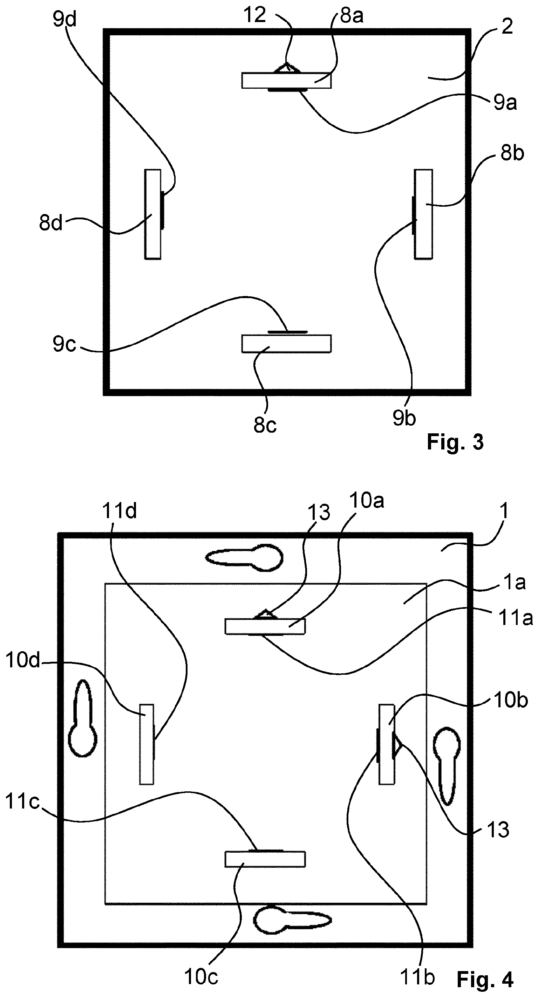

- Fig. 3: eine Unteransicht auf einen Bedienaufsatz gemäß den Figuren 1 und 2 und
- Fig. 4: eine Aufsicht auf die Oberseite eines erfindungsgemäßen Gerätesockels.

In den verschiedenen Figuren der Zeichnung sind gleiche Teile stets mit denselben Bezugszeichen versehen.

Zu der anschließenden Beschreibung wird beansprucht, dass die Erfindung nicht auf das Ausführungsbeispiel und dabei nicht auf alle oder mehrere Merkmale von beschriebenen Merkmalskombinationen beschränkt ist, vielmehr ist jedes einzelne Teilmerkmal des Ausführungsbeispiels auch losgelöst von allen anderen im Zusammenhang damit beschriebenen Teilmerkmalen für sich von Bedeutung für den Gegenstand der Erfindung.

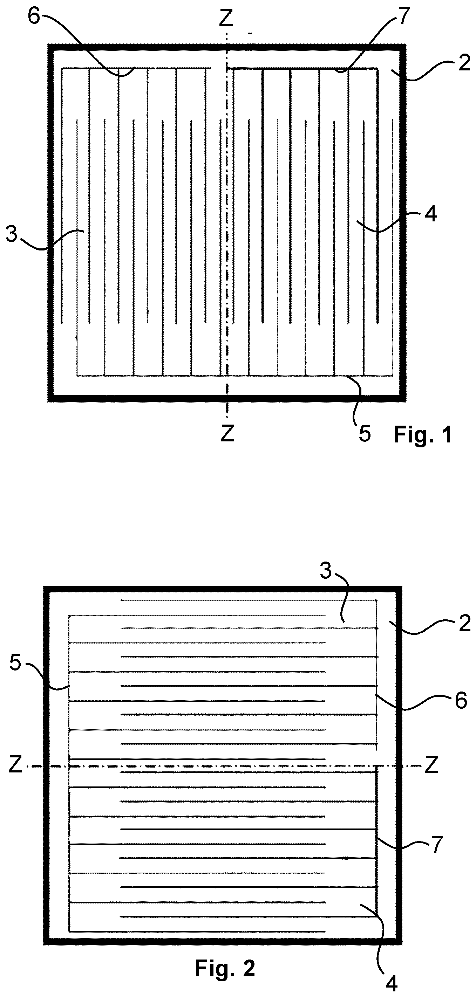

Ein erfindungsgemäßes elektronisches Elektroinstallationsgerät umfasst einen Gerätesockel 1, der insbesondere für einen Unterputzeinbau geeignet ist, und weiterhin weist das erfindungsgemäße elektronische Elektroinstallationsgerät einen Bedienaufsatz 2 auf, der im Gebrauchszustand des elektronischen Elektroinstallationsgerätes, z. B. im eingebauten Zustand des Gerätesockels 1, auf dessen freier nach außen weisenden Oberseite 1a angeordnet ist. Der Gerätesockel weist zudem an seinem Umfang einen Tragring 1b zur Befestigung des Gerätesockels 1 in einer Montageöffnung auf. Der Bedienaufsatz 2 weist an seiner im befestigten Zustand auf dem Gerätesockel von diesem weg weisenden Oberseite 1a eine kapazitive Sensorfläche auf, die insbesondere in zwei Sensorteilflächen 3, 4 unterteilt ist. Diese Sensorteilflächen 3, 4 sind insbesondere gleich groß und sind gleichmäßig auf der Oberfläche des Bedienaufsatzes 2 aufgeteilt. Im dargestellten Ausführungsbeispiel haben die Sensorteilflächen 3, 4 eine rechteckige Form und der Bedienaufsatz 2 hat eine quadratische Form. Gemäß einer nicht dargestellten Ausführung hat der Bedienaufsatz 2 eine runde Form. In Fig. 1 verlaufen die gleich großen Sensorteilflächen 3, 4 in vertikaler Richtung und in Fig. 2 verlaufen diese beiden Sensorteilflächen 3, 4 in horizontaler Richtung. Die Sensorteilflächen 3, 4 verlaufen jeweils beidseitig zu einer Trennlinie Z. Die beiden Sensorteilflächen 3, 4 weisen jeweils eine gemeinsame Masse-Leiterbahn 5 und jeweils eine spannungsführende Leiterbahn 6, 7 auf, wobei die Leiterbahnen 5, 6 und 7 jeweils in den Sensorteilflächen 3, 4 eine kapazitive Struktur bilden. An seiner im montierten Zustand zum Gerätesockel 1 weisenden Unterseite weist der Bedienaufsatz 2 eine Steckverbindungsvorrichtung auf, die eine kraftschlüssige oder kraftformschlüssige Verbindung mit dem Gerätesockel 1 ermöglicht. Im dargestellten Ausführungsbeispiel besteht die Steckverbindungsvorrichtung aus insbesondere vier Steckfortsätzen 8a, 8b, 8c und 8d. Dabei weisen die Steckfortsätze elektrische Kontaktflächen 9a, 9b, 9c, 9d auf. Jeweils eine der in dem Bedienaufsatz 2 integrierten Leiterbahnen 5, 6, 7 ist mit einer der elektrischen Kontaktflächen 9a, 9b, 9c, 9d verbunden. In einer möglichen Ausführungsform weisen nur drei der vier Steckfortsätze 8a, 8b, 8c, 8d eine Kontaktfläche 9a, 9b, 9c auf. Insbesondere kann eine der Kontaktfläche 9a, 9b, 9c, 9d mit keiner der Leiterbahnen 5, 6, 7 verbunden sein. Die Steckfortsätze 8a, 8b, 8c, 8d sind jeweils zueinander um 90° zur Mittelachse X des Bedienaufsatzes 2 versetzt und mit gleich großem Abstand zu dieser angeordnet und derart geometrisch gleich ausgestaltet, dass sie drehsymmetrisch zueinander sind, so dass eine vertikale und horizontale Montage des Bedienaufsatzes 2 möglich ist.

Die erfindungsgemäße Steckverbindungseinrichtung, insbesondere die Steckfortsätze 8a, 8b, 8c und 8d mit den jeweiligen Kontaktflächen 9a, 9b, 9c und die Leiterbahnen 5, 6, 7, bilden mit der kapazitiven Sensorfläche, insbesondere mit den kapazitiven Teilflächen 3, 4, ein einheitliches Bauteil, das z. B. als Spritzgussteil ausgeführt ist. Die kapazitiven Sensorflächen 3, 4 können vorzugsweise als Platine z. B. im Spritzgussteil eingegossen bzw. umspritzt sein oder können auch als Folie, insbesondere als Klebefolie, aufgebracht sein. Die Leiterbahnen 5, 6, 7 können auch aufgedruckt sein.

Die Steckfortsätze 8a, 8b, 8c, 8d besitzen insbesondere eine rechteckige Form, wobei die beiden längeren Rechteckseiten bei zwei gegenüberliegenden Steckfortsätzen 8a, 8c horizontal verlaufen und bei den beiden anderen gegenüberliegenden Steckfortsätzen 8b, 8d vertikal verlaufen. Weiterhin ist es zweckmäßig, wenn die Steckfortsätze 8a, 8b, 8c, 8d eine Feinrastung an ihrer Oberfläche aufweisen, so dass eine rastende Verbindung zum Gerätesockel 1 gegeben ist. Hierdurch ergibt sich eine höhenverstellbare Fixierung des Bedienaufsatzes 2 am Gerätesockel 1, so dass z. B. ein Designrahmen, der zwischen dem Gerätesockel 1 und dem Bedienaufsatz 2 erfindungsgemäß angeordnet sein kann, klemmend fixierbar ist. Zudem kann durch die höhenverstellbare Fixierung ein sogenannter Tapetenausgleich ermöglicht werden, so dass die Funktionalität des Bedienaufsatzes unabhängig von auf dem Tragring des Gerätesockels 1 aufgeklebten Tapetenschichten oder aufgetragenen Farbschichten gewährleistet ist.

Im Gerätesockel 1 sind den Steckfortsätzen 8a, 8b, 8c, 8d zugeordnete und gegenüberliegende sowie im Querschnitt angepasste Einstecköffnungen 10a, 10b, 10c, 10d vorhanden. Diese Einstecköffnungen 10a, 10b, 10c, 10d weisen elektrische Gegenkontaktflächen 11a, 11b, 11c, 11d auf. Die elektrischen Gegenkontaktflächen 11a, 11b, 11c, 11d können z. B. als Schleifkontakte, Klemmkontakte oder Federkontakte ausgebildet sein.

Weiterhin kann es gemäß der Erfindung vorteilhaft sein, wenn an mindestens einem der Steckfortsätze 8a, 8b, 8c, 8d ein nasenartiger Vorsprung 12 ausgebildet ist. Hierbei ist im Gerätesockel 1 in mindestens zwei um 90° zueinander versetzten Einstecköffnungen 10a, 10b, 10c, 10d eine dem Vorsprung 12 angepasste Aufnahmeöffnung 13 ausgebildet. Hierdurch ergibt sich die Möglichkeit, dass mittels der im erfindungsgemäßen Gerätesockel 1 befindlichen elektronischen Auswerteschaltung zwei unterschiedliche Aufsteckpositionen des Bedienaufsatzes 2 detektiert werden können.

Es liegt ebenfalls im Rahmen der Erfindung, wenn die Steckverbindungsvorrichtung aus einem mittigen, im Querschnitt rechteckigen Einsteckfortsatz gebildet ist, an dem an mindestens zwei, vorzugsweise mindestens drei seiner vier Seitenflächen jeweils eine elektrische Kontaktfläche 9a, 9b, 9c, 9d vorhanden ist. Alternativ kann die Steckverbindungsvorrichtung auch aus zwei, insbesondere gegenüberliegenden Steckfortsätzen 8a, 8b, 8c, 8d bestehen, wobei an jedem der Steckfortsätze insbesondere zwei elektrische Kontaktflächen 9a, 9b, 9c, 9d vorhanden sind. Im Gerätesockel 1 sind entsprechend an die Form der Steckfortsätze 8a, 8b, 8c, 8d angepasste Einstecköffnungen 10a, 10b, 10c, 10d vorgesehen, und zwar entweder eine mittig angeordnete, zentrale, im Querschnitt rechteckige Einstecköffnung 10a, 10b, 10c, 10d mit an ihren Seiten ausgebildeten elektrischen Gegenkontaktflächen 11a, 11b, 11c, 11d oder zwei zueinander gegenüberliegende Einstecköffnungen 10a, 10b, 10c, 10d mit jeweils zwei elektrischen Gegenkontaktflächen 11a, 11b, 11c, 11d.

Der erfindungsgemäße Bedienaufsatz 2 kann auch in ein- und zweikanaligen Unterputz-Gerätesockeln 1 verwendet werden, wobei unter einkanalig verstanden wird, dass ein einzelner Verbraucher angesteuert wird und unter zweikanalig verstanden wird, dass zwei unterschiedliche Verbraucher angesteuert werden können oder ein Verbraucher mit zwei Kanälen, wie zum Beispiel ein Rollladen-Aktuator, angesteuert werden kann. Wie beschrieben, kann ein erfindungsgemäßer Bedienaufsatz 2 in zwei Positionen auf dem Gerätesockel 1 aufgesteckt werden, und zwar einmal mit einem vertikalen Verlauf der Seiten der kapazitiven Sensorteilflächen 3, 4, siehe Fig. 1, oder um 90° gedreht mit einem horizontalen Verlauf der Seiten der kapazitiven Sensorteilflächen 3, 4, siehe Fig. 2. Insbesondere sind den Verdrehpositionen unterschiedliche Schaltfunktionen und/oder Bedienkonzepte zugeordnet. Bei der vertikalen Stellung kann sich beispielsweise der nasenartige Vorsprung 12 in einer 12-Uhr-Stellung befinden oder aber um 90° gedreht in einer 3-Uhr-Stellung. Der erfindungsgemäße Gerätesockel 1 ist dabei in der Lage, durch die Aufsteckfortsätze 8a, 8b, 8c, 8d ein horizontales Aufbringen von einem vertikalen Aufbringen des Bedienaufsatzes 2 zu unterscheiden und die dadurch gewählte Funktion programmtechnisch über seine Gegenkontaktflächen 11a, 11b, 11c, 11d zu erkennen und seine jeweilige Funktion voreinzustellen.

Ein einkanaliger Unterputzeinsatz stellt dabei z. B. folgende Funktionen zur Verfügung:
1. Bei vertikal aufgestecktem Bedienaufsatz 2 (Bedienung links/rechts) wird die Bedienfläche gesamtheitlich als eine Funktionsfläche erkannt und die Aktorik im Gerätesockel 1 in einer "Toggle-Funktion" (Schaltfunktion) angesteuert, d. h. Kurzbedienung = Ein/Aus und Langbedienung = Dimmen Auf/Ab.
2. Bei horizontal gestecktem Bedienaufsatz 2 (Bedienung oben/unten) wird die Bedienfläche separat ausgewertet und die Aktorik im Gerätesockel 1 gezielt angesteuert, d. h. Kurz-/Langbedienung oben = Ein/Aufdimmen und Kurz-/Langbedienung unten = Aus/Abdimmen.

Ein zweikanaliger Gerätesockel 1 kann darüber hinaus seine gesamte Arbeitsweise in Abhängigkeit von der Steckposition des Bedienaufsatzes 2 umstellen und folgende Funktionen ebenfalls zur Verfügung stellen:
1. Bei vertikal aufgestecktem Bedienaufsatz 2 (Bedienung links/rechts) arbeitet der zweikanalige Gerätesockel 1 in der Funktion Licht als Serienschalter bzw. Lichtdimmer, bei dem über die zuvor beschriebene "Toggle-Funktion" (Schaltfunktion) mit der linken Sensorteilfläche 3 (Fig. 1) der Kanal 1 geschaltet/gedimmt wird und mit der rechten Sensorteilfläche 4 (Fig. 1) der Kanal 2.
2. Bei horizontal gestecktem Bedienaufsatz 2 (Fig. 2) (Bedienung oben/unten) arbeitet der zweikanalige Gerätesockel 1 in der Funktion Jalousie, bei der mit der oberen Sensorteilfläche 3 die Jalousie über Kurz-/Langbedienung in Richtung Auf getippt/gefahren werden kann und mit der unteren Teilfläche 4 in Richtung abwärts.

Gemäß der Erfindung kann vorgesehen sein, dass eine vierte Leiterbahn im Bedienaufsatz vorhanden ist, die einen optischen, akustischen oder vibrierenden Signalgeber im Bedienaufsatz mit einer freien Kontaktfläche 9a, 9b, 9c, 9d verbindet. Die Erfindung ist nicht auf die dargestellten und beschriebenen

Ausführungsbeispiele beschränkt, und der Rahmen der Erfindung wird durch den Schutzumfang der Ansprüche definiert.

### Bezugszeichenliste

- 1: Gerätesockel
- 2: Bedienaufsatz
- 3: Sensorteilfläche
- 4: Sensorteilfläche
- 5: Masse-Leiterbahn
- 6: Leiterbahn
- 7: Leiterbahn
- 8a, 8b, 8c, 8d: Steckfortsätze
- 9a, 9b, 9c, 9d: Kontaktflächen
- 10a, 10b, 10c, 10d: Einstecköffnungen
- 11a, 11b, 11c, 11d: Gegenkontaktflächen
- 12: Vorsprung
- 13: Aufnahmeöffnung

- Z: Trennlinie
- X: Mittelachse

## Patentansprüche

1. Elektronisches Elektroinstallationsgerät, insbesondere für die Gebäudeinstallationstechnik, umfassend einen Gerätesockel (1), in dem eine elektrische Auswerteschaltung angeordnet ist, und einen auf dessen Oberseite angeordneten Bedienaufsatz (2), wobei
der Bedienaufsatz (2) aus einem Formteil besteht, das an seiner vom Gerätesockel (1) abgekehrten Oberseite eine kapazitive Sensorfläche (3, 4) aufweist, wobei an seiner dem Gerätesockel (1) zugekehrten Unterseite eine Steckverbindungsvorrichtung (8a, 8b, 8c, 8d) ausgebildet ist, die mit dem Gerätesockel (1) zumindest kraftschlüssig verbindbar ist, **dadurch gekennzeichnet, dass** die Steckverbindungsvorrichtung (8a, 8b, 8c, 8d) mindestens zwei voneinander beabstandete elektrische Kontaktflächen (9a, 9b, 9c, 9d) aufweist, die über in dem Formteil ausgebildete elektrische Leiterbahnen (5, 6, 7) mit der Sensorfläche (3, 4) elektrisch verbindbar sind und im Gerätesockel (1) den elektrischen Kontaktflächen (9a, 9b, 9c, 9d) zugeordnete elektrische Gegenkontaktflächen (11a, 11d) aufweisen, wobei in dem Bedienaufsatz (2) die kapazitive Sensorfläche (3, 4) und die elektrischen Leiterbahnen (5, 6, 7) integriert sind und zudem mechanische Verbindungsmittel zwischen dem Bedienaufsatz (2) und dem Gerätesockel (1) und die elektrischen Kontakte (9a, 9b, 9c, 9d) mit dem Bedienaufsatz (2) einteilig verbunden sind.

2. Elektronisches Elektroinstallationsgerät nach Anspruch 1,
**dadurch gekennzeichnet, dass** die Sensorfläche (3, 4) sowie die Steckverbindungsvorrichtung (8a, 8b, 8c, 8d) mit den elektrischen Kontaktflächen (9a, 9b, 9c, 9d) und die elektrischen Gegenkontaktflächen (11a, 11d) derart ausgebildet und angeordnet sind, dass eine Verdrehung des Bedienaufsatzes (2) in zwei um 90° zueinander versetzt angeordnete Positionen möglich ist, wobei den Verdrehpositionen unterschiedliche Schaltfunktionen und/oder unterschiedliche Bedienkonzepte zugeordnet sind.

3. Elektronisches Elektroinstallationsgerät nach Anspruch 1 oder 2,
**dadurch gekennzeichnet, dass** die kapazitive Sensorfläche in zwei zueinander klappsymmetrisch angeordnete, voneinander getrennte rechteckige kapazitive Sensorteilflächen (3, 4) aufgeteilt ist.

4. Elektronisches Elektroinstallationsgerät nach Anspruch 3,
**dadurch gekennzeichnet, dass** die kapazitiven Sensorteilflächen (3, 4) über drei Leiterbahnen (5, 6, 7), und zwar einer gemeinsamen auf Masse liegenden Leiterbahn (5) und jeweils einer spannungsführenden Leiterbahn (6, 7) mit drei zugeordneten elektrischen Kontaktflächen (9a, 9b, 9c, 9d) der Steckverbindungsvorrichtung (8a, 8b, 8c, 8d) verbunden sind.

5. Elektronisches Elektroinstallationsgerät nach Anspruch 4,
**dadurch gekennzeichnet, dass** die drei elektrischen Kontaktflächen (9a, 9b, 9c, 9d) jeweils zueinander um einen gleichen Winkel, insbesondere um 90°, versetzt sind.

6. Elektronisches Elektroinstallationsgerät nach Anspruch 5,
**dadurch gekennzeichnet, dass** die Steckverbindungsvorrichtung aus vier jeweils in gleichen Abständen zur Mittelachse des Bedienaufsatzes (2) angeordneten und um 90° zueinander versetzten, im Querschnitt rechteckigen Steckfortsätzen (8a, 8b, 8c, 8d) gebildet ist und die elektrischen Kontaktflächen (9a, 9b, 9c, 9d) an drei der Steckfortsätze (8a -8d) ausgebildet sind.

7. Elektronisches Elektroinstallationsgerät nach einem der Ansprüche 1 bis 6, **dadurch gekennzeichnet, dass** die Steckverbindungsvorrichtung aus einem mittigen, im Querschnitt rechteckigen Einsteckfortsatz gebildet ist, an dem an seinen vier Seitenflächen jeweils eine elektrische Kontaktfläche (9a - 9d) vorhanden ist, oder die Steckverbindungsvorrichtung auch aus zwei Steckfortsätzen besteht, wobei an jedem der Steckfortsätze zwei elektrische Kontaktflächen vorhanden sind.

8. Elektronisches Elektroinstallationsgerät nach Anspruch 6 oder 7,
**dadurch gekennzeichnet, dass** in dem Gerätesockel (1) den Steckfortsätzen (8a, 8b, 8c, 8d) zugeordnete und im Querschnitt angepasste Einstecköffnungen (10a, 10b, 10c, 10d) ausgebildet sind, die jeweils eine elektrische Gegenkontaktfläche (11a, 11b, 11c, 11d) aufweisen.

9. Elektronisches Elektroinstallationsgerät nach einem oder mehreren der Ansprüche 1 bis 8,
**dadurch gekennzeichnet, dass** die im Gerätesockel (1) angeordnete elektrische Schalteinrichtung zum Ansteuern eines Verbrauchers oder zweier Verbraucher ausgelegt ist.

10. Elektronisches Elektroinstallationsgerät nach einem der Ansprüche 6 bis 8, **dadurch gekennzeichnet, dass** an einem der Steckfortsätze (8a -8d) ein nasenartiger Vorsprung (12) ausgebildet ist und im Gerätesockel (1) in der den Vorsprung (12) aufweisenden Steckfortsatz (8a - 8d) zugeordneten Einstecköffnung (10a, 10b, 10c, 10d) sowie der hierzu um 90° versetzten Einstecköffnung (10a, 10b, 10c, 10d) eine dem Vorsprung (12) angepasste Aufnahmeöffnung (13) ausgebildet ist.

11. Elektronisches Elektroinstallationsgerät nach einem der Ansprüche 1 bis 10, **dadurch gekennzeichnet, dass** der Bedienaufsatz (2) eine rechteckige, insbesondere quadratische oder eine runde Form hat und mittig über dem Gerätesockel (1) angeordnet ist, so dass die Mittelachsen (X) beider Teile, nämlich des Bedienaufsatzes (2) und des Gerätesockels (1), zusammenfallen.

12. Elektronisches Elektroinstallationsgerät nach Anspruch 11,
**dadurch gekennzeichnet, dass** der Bedienaufsatz (2) den Gerätesockel (1) abdeckt.

13. Elektronisches Elektroinstallationsgerät nach einem der Ansprüche 1 bis 12, **dadurch gekennzeichnet, dass** die Gegenkontaktflächen (11a, 11b, 11c, 11d) als Schleifkontakte, Klemmkontakte oder Federkontakte ausgebildet sind.

14. Elektronisches Elektroinstallationsgerät nach einem der Ansprüche 1 bis 13, **dadurch gekennzeichnet, dass** an der Umfangsfläche der Steckfortsätze (8a, 8b, 8c, 8d) eine Feinzahnung ausgebildet ist.

15. Elektronisches Elektroinstallationsgerät nach einem der Ansprüche 4 bis 6, **dadurch gekennzeichnet, dass** eine vierte Leiterbahn im Bedienaufsatz (2) ausgebildet ist, die mit einem optischen, akustischen oder vibrierenden Signalgeber im Bedienaufsatz (2) verbunden ist, wobei die vierte Leiterbahn mit einer freien Kontaktfläche der Verbindungsvorrichtung verbunden ist.

16. Elektronisches Elektroinstallationsgerät nach einem der Ansprüche 3 bis 15, **dadurch gekennzeichnet, dass** die Sensorteilflächen (3, 4) gleich groß und gleichmäßig auf der Oberfläche des Bedienaufsatzes (2) zueinander symmetrisch aufgeteilt sind, wobei insbesondere die Sensorteilflächen (3, 4) eine rechteckige Form aufweisen.

17. Elektronisches Elektroinstallationsgerät nach einem der Ansprüche 1 bis 16, **dadurch gekennzeichnet, dass** die kapazitive Sensorfläche (3, 4) als eine in der Wandung des Formteils umspritzte elektrisch leitfähige Sensorfläche ausgebildet ist.

18. Elektronisches Elektroinstallationsgerät nach einem der Ansprüche 1 bis 17, **dadurch gekennzeichnet, dass** die kapazitive Sensorfläche (3, 4) als eine auf das Formteil gedruckte oder geklebte elektrisch leitfähigen Sensorfläche ausgebildet ist.

## Claims

1. An electronic electrical installation device, in particular for building installation technology, comprising a device base (1) in which an electrical evaluation circuit is arranged, and an operating attachment (2) arranged on an upper side thereof, wherein
the operating attachment (2) consists of a moulded part which has a capacitive sensor surface (3, 4) on an upper side thereof facing away from the device base (1), wherein a plug connection device (8a, 8b, 8c, 8d) is formed on an underside thereof facing the device base (1), which plug connection device is connectable to the device base (1) at least in a force-fitting manner, **characterised in that** the plug connection device (8a, 8b, 8c, 8d) has at least two electrical contact surfaces (9a, 9b, 9c, 9d) spaced apart from one another, which are electrically connectable to the sensor surface (3, 4) via electrical conductor tracks (5, 6, 7) formed in the moulded part, and in the device base (1) there are electrical mating contact surfaces (11a, 11d) assigned to the electrical contact surfaces (9a, 9b, 9c, 9d), wherein the capacitive sensor surface (3, 4) and the electrical conductor tracks (5, 6, 7) are integrated in the operating attachment (2), and furthermore mechanical connection means between the operating attachment (2) and the device base (1) and the electrical contacts (9a, 9b, 9c, 9d) are integrally connected to the operating attachment (2).

2. The electronic electrical installation device according to claim 1,
**characterised in that** the sensor surface (3, 4) as well as the plug connection device (8a, 8b, 8c, 8d) with the electrical contact surfaces (9a, 9b, 9c, 9d) and the electrical mating contact surfaces (11a, 11d) are formed and arranged such that a rotation of the operating attachment (2) into two positions offset by 90° relative to one another is possible, wherein different switching functions and/or different operating concepts are assigned to the rotational positions.

3. The electronic electrical installation device according to claim 1 or 2,
**characterised in that** the capacitive sensor surface is divided into two separate rectangular capacitive sensor partial surfaces (3, 4) arranged in a fold-symmetrical manner relative to one another.

4. The electronic electrical installation device according to claim 3,
**characterised in that** the capacitive sensor partial surfaces (3, 4) are connected via three conductor tracks (5, 6, 7), namely a common conductor track (5) connected to earth and in each case a voltage-carrying conductor track (6, 7), to three assigned electrical contact surfaces (9a, 9b, 9c, 9d) of the plug connection device (8a, 8b, 8c, 8d).

5. The electronic electrical installation device according to claim 4,
**characterised in that** the three electrical contact surfaces (9a, 9b, 9c, 9d) are each offset relative to one another by an equal angle, in particular by 90°.

6. The electronic electrical installation device according to claim 5,
**characterised in that** the plug connection device is formed from four plug projections (8a, 8b, 8c, 8d) which are each arranged at equal distances from the central axis of the operating attachment (2) and are offset by 90° relative to one another and are rectangular in cross-section, and the electrical contact surfaces (9a, 9b, 9c, 9d) are formed on three of the plug projections (8a-8d).

7. The electronic electrical installation device according to any one of claims 1 to 6, **characterised in that** the plug connection device is formed from a central insertion projection which is rectangular in cross-section and on four side surfaces of which there is in each case an electrical contact surface (9a - 9d), or the plug connection device also consists of two plug projections, wherein two electrical contact surfaces are present on each of the plug projections.

8. The electronic electrical installation device according to claim 6 or 7,
**characterised in that** insertion openings (10a, 10b, 10c, 10d) which are assigned to the plug projections (8a, 8b, 8c, 8d) and are adapted in cross-section are formed in the device base (1), which insertion openings each have an electrical mating contact surface (11a, 11b, 11c, 11d).

9. The electronic electrical installation device according to one or more of claims 1 to 8, **characterised in that** the electrical switching device arranged in the device base (1) is designed for controlling one consumer or two consumers.

10. The electronic electrical installation device according to any one of claims 6 to 8, **characterised in that** a nose-like projection (12) is formed on one of the plug projections (8a-8d), and in the device base (1) a receiving opening (13) adapted to the projection (12) is formed in the insertion opening (10a, 10b, 10c, 10d) assigned to the plug projection (8a - 8d) having the projection (12) as well as in the insertion opening (10a, 10b, 10c, 10d) offset by 90° relative thereto.

11. The electronic electrical installation device according to any one of claims 1 to 10, **characterised in that** the operating attachment (2) has a rectangular, in particular square, or a round shape and is arranged centrally above the device base (1), such that the central axes (X) of both parts, namely of the operating attachment (2) and of the device base (1), coincide.

12. The electronic electrical installation device according to claim 11**,**
**characterised in that** the operating attachment (2) covers the device base (1).

13. The electronic electrical installation device according to any one of claims 1 to 12**, characterised in that** the mating contact surfaces (11a, 11b, 11c, 11d) are formed as sliding contacts, clamping contacts or spring contacts.

14. The electronic electrical installation device according to any one of claims 1 to 13, **characterised in that** a fine toothing is formed on the circumferential surface of the plug projections (8a, 8b, 8c, 8d).

15. The electronic electrical installation device according to any one of claims 4 to 6**, characterised in that** a fourth conductor track is formed in the operating attachment (2), which fourth conductor track is connected to an optical, acoustic or vibrating signal generator in the operating attachment (2), wherein the fourth conductor track is connected to a free contact surface of the connection device.

16. The electronic electrical installation device according to any one of claims 3 to 15, **characterised in that** the sensor partial surfaces (3, 4) are of equal size and are divided uniformly and symmetrically relative to one another on the surface of the operating attachment (2), wherein in particular the sensor partial surfaces (3, 4) have a rectangular shape.

17. The electronic electrical installation device according to any one of claims 1 to 16, **characterised in that** the capacitive sensor surface (3, 4) is formed as an electrically conductive sensor surface overmoulded in the wall of the moulded part.

18. The electronic electrical installation device according to any one of claims 1 to 17, **characterised in that** the capacitive sensor surface (3, 4) is formed as an electrically conductive sensor surface printed or adhered onto the moulded part.

## Revendications

1. Appareil d'installation électrique électronique, en particulier pour la technique d'installation de bâtiments, comprenant un socle d'appareil (1), dans lequel est disposé un circuit d'évaluation électrique, et un élément de commande (2) disposé sur sa face supérieure, dans lequel l'élément de commande (2) est constitué d'une pièce moulée qui présente sur sa face supérieure opposée au socle d'appareil (1) une surface de capteur capacitive (3, 4), un dispositif de connexion enfichable (8a, 8b, 8c, 8d) étant formé sur sa face inférieure tournée vers le socle d'appareil (1), lequel dispositif peut être relié au socle d'appareil (1) au moins par liaison par adhérence, **caractérisé en ce que** le dispositif de connexion enfichable (8a, 8b, 8c, 8d) présente au moins deux surfaces de contact électriques (9a, 9b, 9c, 9d) espacées l'une de l'autre, lesquelles peuvent être reliées électriquement à la surface de capteur (3, 4) par l'intermédiaire de pistes conductrices électriques (5, 6, 7) formées dans la pièce moulée, et dans le socle d'appareil (1) présentent des surfaces de contre-contact électriques (11a, 11d) associées aux surfaces de contact électriques (9a, 9b, 9c, 9d), la surface de capteur capacitive (3, 4) et les pistes conductrices électriques (5, 6, 7) étant intégrées dans l'élément de commande (2) et en outre des moyens de liaison mécaniques entre l'élément de commande (2) et le socle d'appareil (1) et les contacts électriques (9a, 9b, 9c, 9d) étant reliés d'une seule pièce avec l'élément de commande (2).

2. Appareil d'installation électrique électronique selon la revendication 1,
**caractérisé en ce que** la surface de capteur (3, 4) ainsi que le dispositif de connexion enfichable (8a, 8b, 8c, 8d) avec les surfaces de contact électriques (9a, 9b, 9c, 9d) et les surfaces de contre-contact électriques (11a, 11d) sont conçus et disposés de telle sorte qu'une rotation de l'élément de commande (2) dans deux positions décalées de 90° l'une par rapport à l'autre est possible, des fonctions de commutation différentes et/ou des concepts de commande différents étant associés aux positions de rotation.

3. Appareil d'installation électrique électronique selon la revendication 1 ou 2,
**caractérisé en ce que** la surface de capteur capacitive est divisée en deux surfaces de capteur partielles capacitives rectangulaires (3, 4) séparées l'une de l'autre et disposées de manière symétrique par pliage l'une par rapport à l'autre.

4. Appareil d'installation électrique électronique selon la revendication 3,
**caractérisé en ce que** les surfaces de capteur partielles capacitives (3, 4) sont reliées par l'intermédiaire de trois pistes conductrices (5, 6, 7), à savoir une piste conductrice commune (5) reliée à la masse et respectivement une piste conductrice (6, 7) sous tension, à trois surfaces de contact électriques (9a, 9b, 9c, 9d) associées du dispositif de connexion enfichable (8a, 8b, 8c, 8d).

5. Appareil d'installation électrique électronique selon la revendication 4,
**caractérisé en ce que** les trois surfaces de contact électriques (9a, 9b, 9c, 9d) sont respectivement décalées l'une par rapport à l'autre d'un même angle, en particulier de 90°.

6. Appareil d'installation électrique électronique selon la revendication 5,
**caractérisé en ce que** le dispositif de connexion enfichable est formé de quatre prolongements enfichables (8a, 8b, 8c, 8d) de section rectangulaire, disposés respectivement à des distances égales de l'axe central de l'élément de commande (2) et décalés de 90° l'un par rapport à l'autre, et les surfaces de contact électriques (9a, 9b, 9c, 9d) sont formées sur trois des prolongements enfichables (8a - 8d).

7. Appareil d'installation électrique électronique selon l'une des revendications 1 à 6, **caractérisé en ce que** le dispositif de connexion enfichable est formé d'un prolongement d'insertion central de section rectangulaire, sur lequel une surface de contact électrique (9a - 9d) est présente sur chacune de ses quatre faces latérales, ou le dispositif de connexion enfichable est également constitué de deux prolongements enfichables, deux surfaces de contact électriques étant présentes sur chacun des prolongements enfichables.

8. Appareil d'installation électrique électronique selon la revendication 6 ou 7, **caractérisé en ce que** dans le socle d'appareil (1) sont formées des ouvertures d'insertion (10a, 10b, 10c, 10d) associées aux prolongements enfichables (8a, 8b, 8c, 8d) et adaptées en section, lesquelles présentent respectivement une surface de contre-contact électrique (11a, 11b, 11c, 11d).

9. Appareil d'installation électrique électronique selon une ou plusieurs des revendications 1 à 8,
**caractérisé en ce que** le dispositif de commutation électrique disposé dans le socle d'appareil (1) est conçu pour commander un consommateur ou deux consommateurs.

10. Appareil d'installation électrique électronique selon l'une des revendications 6 à 8, **caractérisé en ce que** sur l'un des prolongements enfichables (8a - 8d) est formée une saillie en forme de nez (12) et dans le socle d'appareil (1), dans l'ouverture d'insertion (10a, 10b, 10c, 10d) associée au prolongement enfichable (8a - 8d) présentant la saillie (12) ainsi que dans l'ouverture d'insertion (10a, 10b, 10c, 10d) décalée de 90° par rapport à celle-ci, est formée une ouverture de réception (13) adaptée à la saillie (12).

11. Appareil d'installation électrique électronique selon l'une des revendications 1 à 10**, caractérisé en ce que** l'élément de commande (2) a une forme rectangulaire, en particulier carrée, ou une forme ronde et est disposé de manière centrée au-dessus du socle d'appareil (1), de sorte que les axes centraux (X) des deux parties, à savoir de l'élément de commande (2) et du socle d'appareil (1), coïncident.

12. Appareil d'installation électrique électronique selon la revendication 11**,**
**caractérisé en ce que** l'élément de commande (2) recouvre le socle d'appareil (1).

13. Appareil d'installation électrique électronique selon l'une des revendications 1 à 12**, caractérisé en ce que** les surfaces de contre-contact (11a, 11b, 11c, 11d) sont réalisées sous forme de contacts à frottement, de contacts à serrage ou de contacts à ressort.

14. Appareil d'installation électrique électronique selon l'une des revendications 1 à 13**, caractérisé en ce que** sur la surface périphérique des prolongements enfichables (8a, 8b, 8c, 8d) est formée une denture fine.

15. Appareil d'installation électrique électronique selon l'une des revendications 4 à 6**, caractérisé en ce que** une quatrième piste conductrice est formée dans l'élément de commande (2), laquelle est reliée à un émetteur de signal optique, acoustique ou vibrant dans l'élément de commande (2), la quatrième piste conductrice étant reliée à une surface de contact libre du dispositif de connexion.

16. Appareil d'installation électrique électronique selon l'une des revendications 3 à 15, **caractérisé en ce que** les surfaces de capteur partielles (3, 4) sont de taille égale et réparties de manière uniforme et symétrique l'une par rapport à l'autre sur la surface de l'élément de commande (2), les surfaces de capteur partielles (3, 4) présentant en particulier une forme rectangulaire.

17. Appareil d'installation électrique électronique selon l'une des revendications 1 à 16, **caractérisé en ce que** la surface de capteur capacitive (3, 4) est réalisée sous forme d'une surface de capteur électriquement conductrice surmoulée dans la paroi de la pièce moulée.

18. Appareil d'installation électrique électronique selon l'une des revendications 1 à 17, **caractérisé en ce que** la surface de capteur capacitive (3, 4) est réalisée sous forme d'une surface de capteur électriquement conductrice imprimée ou collée sur la pièce moulée.
